# EUROPEAN PATENT APPLICATION

(11) **EP 2 133 736 A1**
(43) Date of publication of application: **16.12.2009**
(21) Application number: 07720808.0
(22) Date of filing: 16.04.2007
(51) Int. Cl.: G02F 1/133, C09K 11/00, G02B 5/22

(54) **DISPLAY APPARATUS AND CELLULAR PHONE,COMPUTER AND TELEVISION INCLUDING THE SAME**

(30) Priority: 06.03.2007 CN 200710037859
(71) Applicant: Sun, Runwen, Shanghai 200235 (CN)
(72) Inventor: Sun, Runwen, Shanghai 200235 (CN)
(74) Representative: Stuttard, Garry Philip
(86) International application number: PCT/CN2007/001235
(87) International publication number: WO 2008/106833

(57) **Abstract**

A display apparatus (100') includes a substrate (115a) and a light switch (210). A light source (310') is provided at the side of the substrate (115a) and emits light of which wavelength is in the range of ultraviolet or cyan. A polarizing sheet (116), as well as a photoluminescence film (110'), is provided in front of the light source (310'). Under the excitation of the light source (310'), the photoluminescence film (110') can emit red light, green light, blue light and/or intermediate color light among red, green and blue.

## Description

### Technical Field

The present invention relates to a display device and a cellular phone, a computer and a television including the same.

### Background

Liquid crystal displays (LCD) are used in a wide range from 1 inch scaled cellular phones to 40 inches scaled or larger television sets as well as in computers. A liquid crystal display comprises a liquid crystal cell, peripheral driving IC (Intergrated Circuit) and circuits, a light source and related mechanisms behind the liquid crystal cell. The initially used liquid crystal display was dominantly of passive driven TN (Twisted Nematic) and STN (Super Twisted Nematic) types, but the currently dominant type is a transmissive a-Si TFT (amorphous silicon thin-film transistor) active matrix (AM) driven LCD, i.e., a-Si TFT-AMLCD. Liquid crystal display monitors are generally used in a TN mode, whereas liquid crystal display television sets have a wide-angel mode such as IPS (In Plane Switching), MVA (Multi-domain Vertical Alignment), PVA (Patterned Vertical Alignment), OCB (Optically Compensated Bend), and FLC (Ferroelectric Liquid Crystal) etc.

The liquid crystal cell comprises a first substrate and a second substrate stuck together with a liquid crystal filled therebetween. The substrates are usually made of glass with a thickness in a range of 0.2-1.1mm. They may alternatively be made from plastics or metal foils. A distance of about 1-10µm is spaced between the first substrate and the second substrate with a great accuracy. The second substrate of an active matrix liquid crystal display is provided with gate lines, data lines and diode with electrodes for driving the pixels. In a passive driven liquid crystal display, such as a TN or STN-LCD, gate lines, data lines as the pixel electrodes, orthogonal to each other, are provided on the two opposite substrates respectively. In the active liquid crystal display, thin-film transistors (TFT) or diodes the switch elements, are provided at intersections of the gate lines and data lines on the second substrate. The first substrate is provided with patterns which are composed of a plurality of red, green and blue fundamental colors arranged alternatively and accurately located corresponding to those of the individual pixels on the second substrate. A polarizer is glued respectively to the back side of each of the first and second substrates. In general, the pixel electrodes are made from a transparent conductive material (typically an alloy of indium and tin oxides) for transferring electric signals through the data lines. Transparent electrodes are also formed on the surface of the first substrate (it is unnecessary for the IPS mode though). A polarization of the liquid crystal is controlled by applying a voltage between the second substrate and the color film electrodes to vary a volume of light transmission through the liquid crystal cell. The second substrate controls the TFT through the gate lines so that they can be switched between ON/OFF states. When a TFT is in an ON state, a static charge is written into the pixel electrodes connected at the source side thereof from the data lines connected at the drain side thereof, so that the liquid crystal is driven by a charged pixel electrode voltage. Storage capacitors parallelly connected to the liquid crystal are fabricated on the pixel driving circuit, such that the charges in the pixel electrode can be substantially maintained at the previous value when the TFT is turned into an OFF state.

A liquid crystal material is sandwiched between the second substrate and the first substrate (i.e., Color Filter, CF). A light source, which is used to supply a white light to a transmissive LCD, is mounted below the second substrate. In the upper and lower substrates are further glued polarizers which play the roles of polarizing the light and detecting the polarization thereof. A PCB (Print Circuit Board) for control circuit and driver IC is mounted to the second substrate. The control circuit and driver IC determines the light volume transmitted through the liquid crystal cell by varying the voltage applied to the liquid crystal cell. The white light passes through the liquid crystal cell and enters the color filter. The color filter includes numerous pixels which consist of red (R), green (G) and blue (B) sub-pixels. When a white light passes through those RGB sub-pixels, except the corresponding monochromatic light of the three RGB fundamental colors, the lights of other colors are absorbed. A typical color LCD utilizes an additive type of non-monochromatic color resultant from a mixture of such RGB lights generated by the color filter, except a RGB dynamic light source and three-piece projection LCOS (Liquid Crystal on Silicon), a DMD (Digital Micromirror Device) and a field sequential color liquid crystal, which can work without a color filter. As the white light passes through a color filter to realize a R, G or B monochromatic display, lights of the remaining colors in the white light are absorbed and the energy loss exceeds 2/3, even if an aperture ratio could be made up to 100%, the lighting efficiency of a typical color liquid crystal display is about 1%, or about 21m/W.

The fabrication of the active matrix liquid crystal display comprises an array forming process, a cell forming process and an assembling process. In the array forming process, the gate lines and the data lines, the thin film transistors (or diodes) and the pixel electrodes are fabricated on a glass substrate. In the cell forming process, a liquid crystal material is injected into the gap between the two substrates and the substrates are stuck and assembled together and then polarizers are attached on the outer side of the liquid crystal panel. The assembling process includes binding the driver IC and print circuit boards, and assembling the light units, etc.

The light source can be configured as a side lighting type, a direct lighting type, a reflective type or a projective type. Liquid crystal display device with one of the above-mentioned four types of light sources will be described with reference to the accompanying drawings.

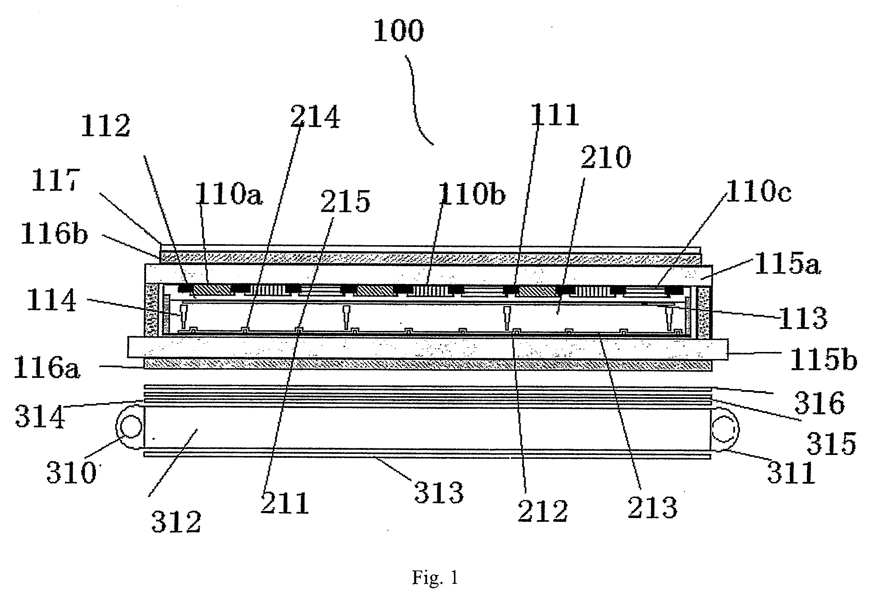

A display device 100 shown in Figs. 1-3 comprises a color filter 110, a white-light source 310, a first substrate 115a and a second substrate 115b; a light valve or switch unit 210 (liquid crystal cell) secured between the first substrate and the second substrate; polarizer 116a, 116b formed with the first substrate and the second substrate respectively; a plurality of gate lines 211 arranged on the upper side of the first substrate; a plurality of data lines 212 arranged on the upper side of the first substrate and intersected with the gate lines; pixel electrodes 113 arranged over the first substrate and cooperating with the data lines; electronic switch elements 214 arranged on the upper side of the first substrate, fit at the intersections between the gate lines and the data lines and connected with the data lines, the gate lines and the pixel electrodes; storage capacitors 215; spacers and structures (protrusions, slits) 114 arranged on the common electrodes of the second substrate; a light guiding plate 312, a reflective plate (film) 313, a diffusion plate (film) 314, a prism film 315; a polarizing and reflective film 316 and etc.

The liquid crystal display device shown in Fig.1 comprises a side lighting source 310, which is arranged on each of both sides of the light guiding plate 312. Over the light guiding plate 312 is the diffusion film (diffusion plate) 315, the prism film 315 and the polarizing and reflective film 316, whereas the reflective plate (reflective film) 313 is on the lower side. The side lighting source type is used in most notebook computer monitors.

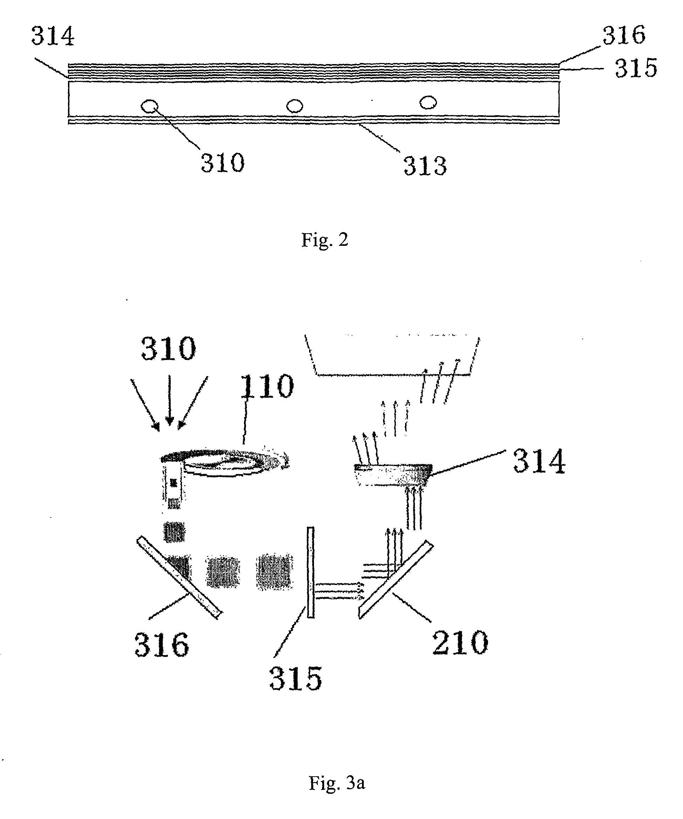

The liquid crystal display device shown in Fig. 2 is a direct lighting source 310 disposed immediately under the diffusion film (diffusion plate) 314 without using a light guiding plate 312, which is different from that of Fig.1. This kind of display device is mostly used in television.

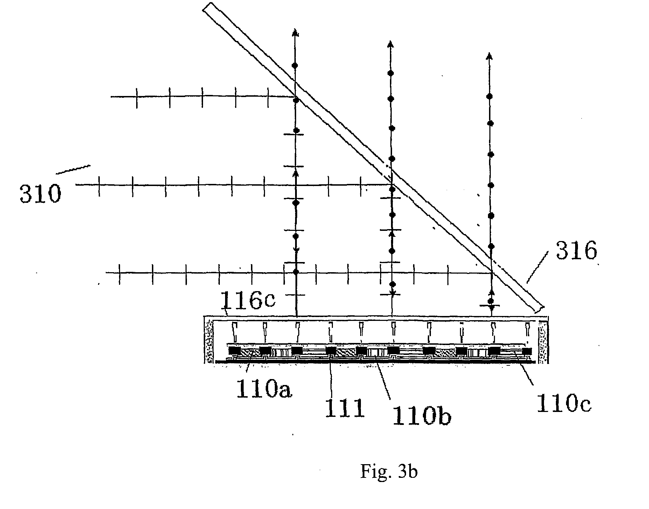

The liquid crystal display device shown in Figs. 3a and 3b comprises a reflective type light sources 310 respectively. These display devices are mostly used in projector displays. It is different from the above described two ones in the positions of the light source 310, the color filter 110, the polarizing and reflective film 316, the prism film 316 and etc. Especially in the reflective type display device shown in Fig. 3b, an elliptic polarizer 116c is used.

Ever since cellular phone began to use liquid crystal displays, continuous efforts have been made to realize a thinner and lighter display with a less power consumption. However, the LCD lighting efficiency is usually less than 1%, for example in a 15 inch notebook computer, wherein the light source consumes 45% of the rated power of the computer. Therefore, an important task is to reduce the power consumption of LCD. Besides, the LCD light source and the color filter are expensive components in a LCD, and for example, account for 30% total cost of a small and mid-sized LCD or 60% of a large-scaled LCD. Therefore, researches have been made for an elevated lighting efficiency, a reduced number of luminescent elements and an enhanced color displaying range.

### Summary of the Invention

A major object of the present invention is to provide a display device with an improved lighting efficiency.

Another object of the present invention is to provide a display device with an elevated display color range and a better color purity.

The objects of the present invention are achieved through the following solutions:
A display device, comprising one or more substrate(s) and light valves disposed on the substrate(s), a light source provided on one side of the substrate, and a polarizer provided in front of the light source, **characterized in that,**
more than one photoluminescence film is provided in front of the light source emitting a light with a wavelength in the range of ultraviolet or cyan, and under the excitation of the light source, the photoluminescence film emits a red light, a green light, a blue light and/or an intermediate color light among red, green and blue lights,
wherein the light emitted from the light source has a peak value at a wavelength in the range of 350-560 nm;
wherein a portion of the photoluminescence film is transparent;
wherein the light source is operated in a static manner or controlled by a display image signal;
wherein an ultraviolet light stopping film is provided on the outer side of the substrate;
wherein the photoluminescence film is provided on a corresponding color filter;
wherein the light source is a cold cathode fluorescent lamp (CCFL), a hot cathode fluorescent lamp (HCFL), a gas discharge light source, an inorganic light emission diode (LED), a planar fluorescent lamp, an organic light emission diode (OLED), an electroluminescent (EL) or field emission device light source;
wherein the light source is a side lighting type, a direct lighting type, a reflective type or a projective type;
wherein the photoluminescence film comprises a plurality of pixels surrounded with a black matrix;
wherein the black matrix is made from a metal, inorganic or organic composition;
wherein the black matrix has a uniform aperture ratio or a varied aperture ratio;
wherein the black matrix has a striped pattern, a triangular pattern, a Taiji-shaped pattern, or a mosaic pattern;
wherein a flattened film is provided over the pixels and the black matrix;
wherein the photoluminescence film is made from an inorganic composition, an organic composition or an inorganic-organic composition and functionally assistant materials, and the photoluminescence quantum efficiency of the photoluminescence film is greater than 10%;
wherein the patterns of the photoluminescence film are formed by a physical vapor deposition, chemical vapor deposition, Sol-Gel method or coating process;
wherein the patterns of the photoluminescence film are formed by means of masking, photolithography, heat and laser transfer printing, laser peeling or printing process, wherein the printing process includes a contact method or a non-contact method;
wherein the photoluminescence film has a partially light-absorptive function which is realized by doping an absorptive material, and an electron transfer between the materials is prevented by an insulating material between the photoluminescent material and the absorptive material;
wherein the photoluminescence film is formed on an absorptive color filter;
wherein the light valve unit is a liquid crystal cell, a digital micro mirror, or plasma and which the plasma emits a monochromatic light or a polychromatic light with a peak value at a wavelength in the range of 350 to 550 nm;
wherein the light valve unit is passive driven or active driven;
wherein in the case of an active light valve unit, the electronic switch elements are thin film transistors, field effect transistors or diodes;
wherein the liquid crystal cell operates in a TN, STN, IPS, VA, OCB, FLC, AFLC (AntiFerroelectric Liquid Crystal) or PDLC (Polymer Dispersion Liquid Crystal) mode; and
wherein the substrate is made of glass, plastic, metal or single-crystalline silicon sheets.

The invention also provides a cellular phone, a television set and a computer comprising said display device.

The present invention has the following advantages:
1. In the display device according to the present invention, the conventional color filter is replaced by a photoluminescence film, such that the display energy utilizing efficiency, the color range and the color purity are greatly improved. Color display is realized by the down conversion of high photon energy light of ultraviolet or cyan monochromatic or polychromatic light, i.e. by the photoluminescence method. If the quantum efficiency of the photoluminescent material employed approximates to 1, the energy utilizing factor of the present invention would be two times over that of the absorptive color filter, the corresponding light emission elements would be reduced by 2/3 and the light source power consumption would be lowered by 2/3. If the quantum efficiency of the photoluminescent material employed is 0.5, the energy utilizing factor of the present invention would be twice that of the absorptive color filter, the corresponding light emission elements would be reduced by 1/2 and the light source power consumption would be lowered by 1/2. In materials science and technology, some photoluminescent materials with high efficiency in visual spectrum (380-780nm), including inorganic compositions, organic compositions and organic-inorganic compositions have been found and widely used. The photoluminescence quantum efficiency of these materials is over 0.5 in general.
2. The display device of the present invention can be improved directly on basis of a current display device, and the luminescent color filter for the blue sub-pixels of the display elements can be omitted, so that the cost can be reduced and the light transmission ratio can be increased, thereby the energy can be better used.
3. In the display device according to the present invention, the light emission elements configured for monochromatic light are reduced, so that the fabrication procedure is simplified, and cost is reduced.
4. In the display device according to the present invention, the light emission elements configured for monochromatic light are same, such that the influence on display performance caused by asynchronous aging process of different color light emission elements is avoided.
5. In the display device according to the present invention, the contrast ratio of the display device is enhanced, and by means of the dynamic control for light sources, such as local brightness control and black screen insertion, the image residue is reduced, such that the contrast ratio could be further enhanced and the energy consumption could be further reduced. In addition, by the down conversion of high photon energy light of ultraviolet or cyan monochromatic or polychromatic light, a better color purity can be generated by choosing a photoluminescent material with a narrower full-width at half-the maximum spectrum, resulting in a greater color display area.

### Brief description of the drawings

Figs.1-3 illustrate schematically a display device of the prior art.
Fig. 4 is a schematic structural view of a side lighting type display device according to the present invention.
Fig. 5 is a schematic structural view of a direct lighting type display device according to the present invention.
Fig. 6a is a schematic structural view of a projective lighting type display device according to the present invention.
Fig. 6b is a schematic structural view of a reflective lighting type display device according to the present invention.
Fig.7 is a schematic view of a photoluminescence film comprising red, yellow, green and blue sub-pixels110a', 110d', 110b' and 110c'.
Fig. 8 is a schematic view of a photoluminescence film comprising red, green, blue and white sub-pixels110a', 110b', 110c' and 110e'.
Fig. 9 is a schematic view of a photoluminescence film comprising red, green, blue, intermediate color or dark blue, blue-green and yellow sub-pixels110a', 110b', 110c', 110g, 110f and 110d.
Fig. 10 is a schematic view of a photoluminescence film formed on array substrate with pixel electrodes 213 formed in an over coating film 112.
Figs. 11 & 12 are schematic views of a photoluminescence film with different pixel aperture ratios.
Fig. 13 is a schematic view of a photoluminescence film functioned partially to absorb light.
Fig. 14 is a schematic view of a color liquid crystal display with a flat light source.
Fig. 15 is a spectral diagram of a first embodiment with conversion peak values of 520 nm (green) and 610 nm (red) under the excitation of a 460 nm wavelength blue light.
Fig. 16 is the first embodiment with conversion peak values of 520 nm (green) and 610 nm (red) under the excitation of a 460 nm wavelength blue light in a color coordinate diagram of CIE1931.

### Embodiments

The technical solution of the present invention will be illustrated by describing the preferable embodiments of the invention in connection with the accompanying figures. The words or terms in the specification related to directions, such as "above", "upper", "lower" and "under" etc, are utilized to describe the directions shown in the accompanying figures, without limiting the invention.

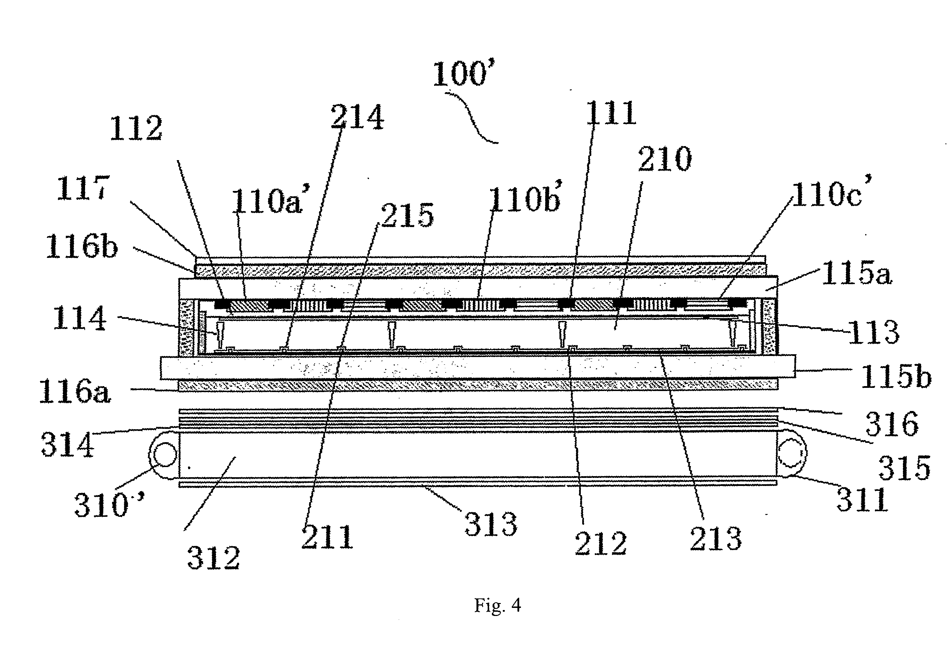

A display device 100' illustrated in Fig. 4 comprises a photoluminescence film 110', a light source 310', a first substrate 115a, and a second substrate 115b; a light valve unit (liquid crystal cell) 210 secured between the first substrate and the second substrate; polarizer 116a, 116b formed with the first substrate and the second substrate; a plurality of gate lines 211 arranged over the second substrate; a plurality of data lines 212 arranged over the second substrate and intersecting the gate lines; pixel electrodes 213 arranged over the second substrate and fit to the data lines; a black matrix 111 arranged among said plurality of sub-pixels of the color luminescence film on the first substrate; a flattened or so called over coating film 112 arranged on the color luminescence film of the first substrate; common electrodes 113 arranged on the flattened film of the first substrate and cooperating with the pixels; electronic switch elements 214 arranged over the second substrate, located at the intersections of the gate lines and the data lines and connected to the data lines, the gate lines and the pixel electrodes; storage capacitors 215; spacers and structures (protrusions, slits) 114 arranged on the common electrodes 113 of the first substrate; a light guiding plate 312, a reflective plate (film) 313, a light diffusion plate (film) 314 and a prism film 315; a polarizing and reflective film 316 and etc.

The structure of the display device 100' is substantially the same as the conventional display device 100 except that the color filter 110 is replaced by the photoluminescence film 110' and a different type of light source 310' is used.

The wavelength of a light emitted from this light source 310' is in the range of a ultraviolet or cyan spectra, preferably 350-550 nm. Under the excitation of the light source 301', the luminescence film 110' can emit sub-pixels of red, green, blue colors and/or an intermediate color among red, green and blue colors.

The light source may be of a side lighting type, a direct lighting type, a reflective lighting type or a projective lighting type as described in the background of the invention and configured similarly to those of the display device shown in Figs. 4-6.

The light source may comprise a CCFL or HCFL light source. It may be a single-tube, a double-tube or a multi-tube fluorescent lamp light source, and the tube has a diameter in a range from 1.8mm to 10mm and a length depending on the dimensions of the LCD panel. To realize an ultraviolet light emission, those skilled may use an ultraviolet ray (visible light should be filtered out) generated from Hg and an inert gas in the CCFL and HCFL conveniently; or an ultraviolet ray (350-400nm) converted from an ultraviolet ray generated from a gas through a fluorescent powder, i.e., phosphor(for example, CaWO4:Bi) in a lighting tube ; or a blue light (with a peak value at 400-500 nm) converted from an ultraviolet ray generated from a gas through a fluorescent powder (for example, CaWO4:Bi) in a lighting tube. A blue fluorescent powder includes a rare earth aluminate luminescent material with a general formula as follows: (Me1) (an alkaline-earth metal 1 such as Ba, Sr) (Me2) 2 (an alkaline-earth 2 such as Mg) 2AlxOy (x=16, y=27)/Eu; a rare earth silicate luminescent material with the following general formula: (Me1) (an alkaline-earth metal 1 such as Ba, Sr) 2 (Me2) (an alkaline-earth 2 such as Al, Mg) 2SixOy (x=2, y=8)/Eu; a rare earth phosphate luminescent material with the following general formula: (Sr, Ca, Ba)10(PO4)6Cl2·B2O3/Eu ; 3(Sr, Ca, Ba)3(PO4)2/Eu ; LaPO4/Eu; a sulphide luminescent material with the following general formula: (Zn, Ca, Sr)S/Ag(Ce, Tm, Eu), Ba(Mg)Al2S4/Eu and etc.

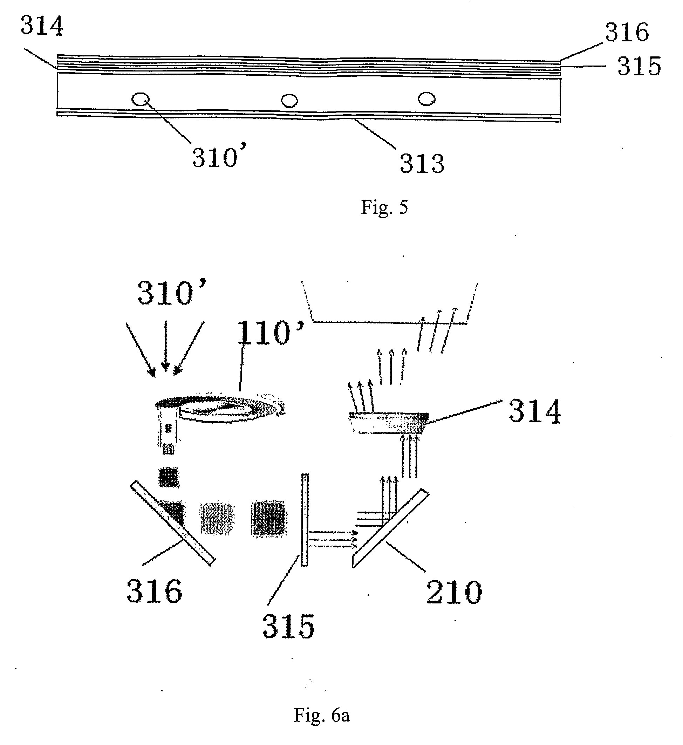

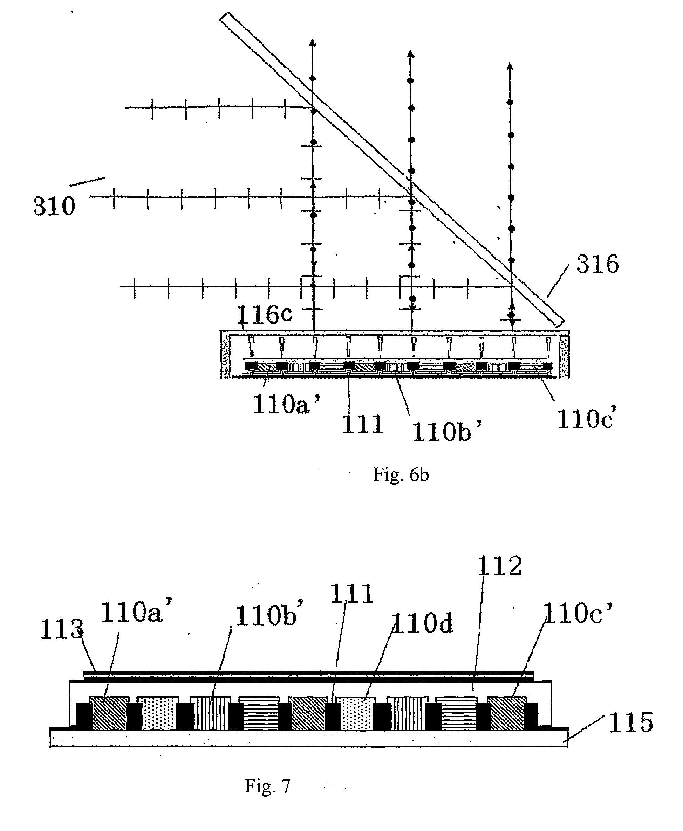

A LED light source may be used. Ultraviolet, blue-green LEDs may be made from known semiconductor materials such as ZnO, SiC, ZnS, ZnSe, Ga(In, Al)N and etc, and a LED made from (Al)Ga(In)N is preferable. The light source comprises LED chips secured on a heat-conductive and electro-conductive substrate (PCB, MC(Metal Core)PCB, F(Flexible)PCB etc) with a control circuit and a power source mounted peripherally. The LED chips generally have a size of 0.3-1mm, the power of a single chip is at 0.001-10W and the typical total power of the light source is up to 10mW-1W. Single-chip packaging or multiple-chip packaging is employed, and multiple groups of LEDs are connected together both in series and in parallel. Particularly, a LED light bar (LED mounted on PCB, MCPCB, FPCB etc) is secured on both sides of the light guiding plate (side lighting type) or on the lower side of the diffusion plate (direct lighting type), and the number of the LEDs used is determined in accordance with the brightness requirements. The light source may be the side lighting type (Fig.4), but the direct lighting type (Fig5), the projective type (Fig.6a) or the reflective type (Fig.6b) may also be used. As to the light source of side lighting type, the LED light bar is mounted on a side of the light guiding plate (Fig. 4), the diffusion film, the prism film and the polarizing and reflective film are mounted above the light guiding plate and the reflective plate is mounted under the light guiding plate. Generally, the LED is supplied by a DC power source, and the brightness thereof is adjusted in a PWM (Pulse Width Modulation) method.

In addition, the light source may be an FFL (Flat Fluorescent Lamp). Blue fluorescent powder includes a rare earth aluminate luminescent material with the following general formula: (Me1) (an alkaline-earth metal 1 such as Ba, Sr) (Me2) 2 (an alkaline-earth 2 such as Mg) 2AlxOy (x=16, y=27)/Eu; a rare earth silicate luminescent material with the following general formula: (Me1) (an alkaline-earth metal 1 such as Ba, Sr) (Me2) (an alkaline-earth 2 such as Al, Mg) 2SixOy (x=2, y=8)/Eu; a rare earth phosphate luminescent material with the following general formula: (Sr, Ca, Ba)10(PO4)6Cl2·B203/Eu ; 3(Sr, Ca, Ba)3(PO4)2/Eu; LaPO4/E; a sulphide luminescent material with the following general formula: (Zn,Ca,Sr)S/Ag(Ce,Tm,Eu), Ba(Mg)Al2S4/Eu and etc. Some blue luminescent inorganic materials are illustrated in the above, but the present invention is not limited to the above materials. The luminescent material satisfying the requirements of the present invention has the following characteristics: an ultraviolet ray having a peak value at a wavelength ranging from 350 nm to 400 nm; a blue light with a peak value at a wavelength ranging from 400 nm to 500 nm; a cyan light with a peak value at a wavelength ranging from 400 nm to 550 nm. The FFL is a flat light source, which can work without a light guiding plate. The FFL light source is secured on the lower side of the diffusion plate (direct lighting type), and the diffusion film, the prism film, the polarizing and reflective film and the outside mechanism and etc. are arranged above the light source.

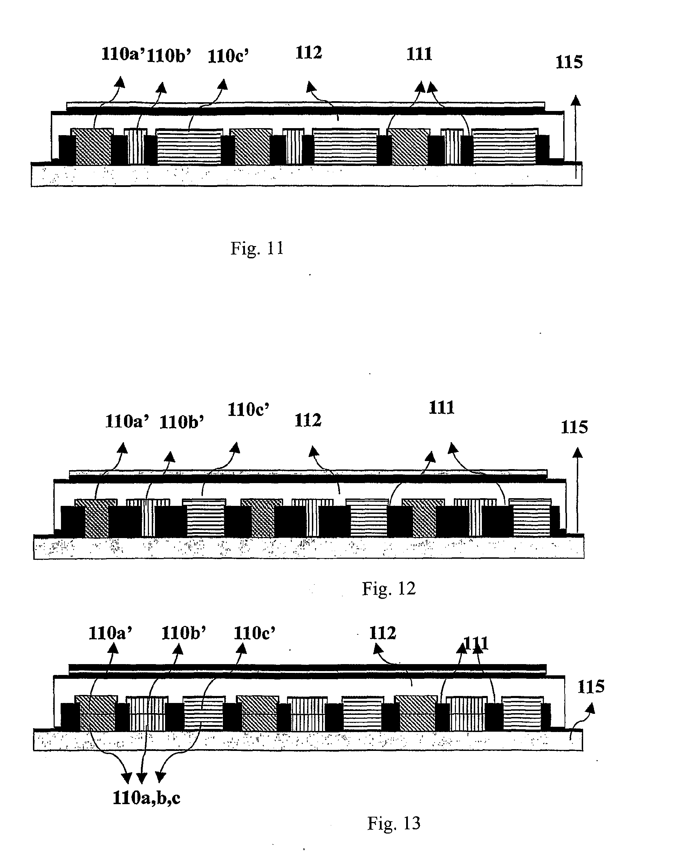

In the present invention an inorganic electroluminescence (EL) light source includes an inorganic powder thin or thick film EL. The blue luminescent material comprises SrS/Ce, SrGa2S4/Ce, BaAl2S4/Eu, BaMgAl2S4/Eu and etc. The inorganic EL is a flat light source of direct lighting type, which can work without a light guiding plate. The thickness of the inorganic EL is in the range of 1-10mm, and the length and width thereof depend on the size of the LCD panel. The inorganic EL is generally energized by an alternating current power. The above EL light source is generally mounted under the diffusion film, the prism film, the polarizing and reflective film and etc. Fig. 13 is a schematic view of an EL light source.

A FED (Field Emission Device) light source, or a SED (Surface-conduction Electron-emitter Device) light source may be used. The blue luminescent material may be selected from ZnS/Ag, ZnO/Zn, SrGa2O4, Sr5(PO4)3Cl/Eu, Y2SiO5/Ce and etc. The FED/SED is a flat light source of direct lighting type, and can thus work without a light guiding plate. The thickness of the FED/SED is in the range of 1-50mm, and the length and width thereof depend on the size of the LCD panel. The above FED light source is generally mounted under the diffusion film, the prism film, the polarizing and reflective film and etc. Fig.13 can also be used as a schematic view of a FED light source.

An OLED (Organic Light Emission Diode) light source may also be used. A blue light OLED is usually made from the following luminescent materials: aromatic compounds including anthracene, anthracene derivatives, fluorene oligomer, fluorene derivatives; heterocyclic compounds such as aniline derivatives; quinoline Al metal complexes. The OLED light source is a flat light source of direct lighting type, and can thus work without a light guiding plate. The thickness of the OLED is in the range of 0.1-10mm, and the length and width thereof depend on the size of the LCD panel. Multiple groups of OLEDs are connected together both in series and in parallel. The OLED is generally driven by a direct current power. The above OLED light source is mounted under the diffusion film, the prism film, the polarizing and reflective film, outside mechanisms and etc. The OLED light source may be a side lighting type or a reflective type. Fig. 13 is a schematic view of an OLED light source.

A photoluminescence film is **characterized in that** itself is a phosphor, and emits a visible light (380-780nm) under the excitation of an ultraviolet (with a peak value at 350-400nm) or cyan (with a peak value at 400-500nm) monochromatic or polychromatic light. At least one peak of the excitation spectrum of the luminescent material overlaps the peak of the ultraviolet or cyan light source. The half width of the spectrum is less than 70nm and the conversion quantum efficiency is greater than 10%. The luminescent material comprises an organic material, an inorganic material, an organic-inorganic composition and a functionally assistant material.

The photoluminescence film is known in the art, and the preparation method thereof can be learned by referring to the preparation method of the blue light conversion member, the red light conversion member and the green light conversion member of the Chinese patent No. 03806079.5, wherein the conversion member is equivalent to the photoluminescence film of the present invention, which will not be described herein.

Inorganic luminescent materials:

Blue inorganic luminescent inorganic materials include the following materials:
a rare earth aluminate luminescent material with the following general formula: (Me1) (an alkaline-earth metal 1 such as Ba, Sr) (Me2) 2 (an alkaline-earth 2 such as Mg) AlxOy (x=16, y=27)/Eu; (Me) (an alkaline-earth metal such as Ba, Sr, Ca, Mg) AlxOy (x=2, y=4)/Eu; a rare earth silicate luminescent material with the following general formula: (Me1) (an alkaline-earth metal 1 such as Ba, Sr, Ca) (Me2) 2 (an alkaline-earth 2 such as Al, Mg) SixOy (x=2, y-6)/Eu; Y2SiO5/Ce; a rare earth phosphate luminescent material with the following general formula: (Sr, Ca, Ba)10(PO4)6Cl2/Eu ; (Sr, Ca, Ba)10(PO4)6Cl2·B203/Eu; 3(Sr, Ca, Ba)3(PO4)2/Eu; LaPO4/Eu; a sulphide luminescent material with the following general formula: (Zn, Ca, Sr)S(Se,O)/Ag(Ce, Tm, Eu), Ba(Mg)Al2S4/Eu and etc.

Green luminescent inorganic materials include the following materials:
a rare earth aluminate luminescent material with the following general formula: Me (an alkaline-earth metal such as Mg) AlxOy (x=11, y=19)/Ce, Tb; Me (an alkaline-earth metal such as Ba, Sr) AlxOy (x=2, y=4)/Eu, Dy; Me1 (an alkaline-earth metal 1 such as Ba, Sr, Ca) Me2 (an alkaline-earth 2 such as Mg) AlxOy (x=10, y=17)/Eu, Mn; a rare earth silicate luminescent material with the following general formula: (Me1) (an alkaline-earth metal 1 such as Ba, Sr, Ca) 2 (Me2) (an alkaline-earth 2 such as Al, Mg) 2SixOy (x=2, y=8)/Eu; Zn2SiO4/Mn; Y2SiO5/Tb; a rare earth phosphate luminescent material with the following general formula: La2O3·0.2SiO2·0.9P2O5/Ce, Tb; LaPO4/Ce,Tb; a sulphide luminescent material with the following general formula: Zn(Ca, Sr)S/Cu,(Ce, Tb); SrGa2S4/Eu, CaAl2S4/Eu; Kelly luminescent material with the following general formula: Y3Al5O12/Ce, ZnS/Mn and etc.

Red luminescent inorganic materials include the following materials:
an oxide (sulphide) with the following general formula: Y(Gd)2O3/Eu, Y2O2S/Eu, Sr(Ca, Zn)S/Eu(Sm); Ca(Sr)Y2S4/Eu, MgGa2O4Eu; a rare earth aluminate luminescent material with the following general formula: Me1 (an alkaline-earth metal 1 such as Sr) Me2 (an alkaline-earth 2 such as Ba) AlxOy/Eu, Mn and etc.

Red, green and blue luminescent materials could be doped with an energy transfer assistant, for example, a green luminescent material doped with a certain amount of blue luminescent materials, a yellow luminescent material doped with a certain amount of green luminescent materials and a red luminescent material doped with a certain amount of yellow or green luminescent material, so that the energy conversion efficiency can be improved.

Luminescent material could be dispersed into a film forming assistant such as polyethylene, polyvinyl chloride, polypropylene, polyacrylate, polymethacrylate, polyvinyl alcohol, polyimide, polystyrene, polycarbonate, phenolic resin, alkyd resin, epoxy resin, polyurethane resin or other known macromolecular materials to form a processable material. Other functionally assistants such as a photosensitive material, a cross-linking material, a dispersion material, a solvent and etc. could be also added at the same time.

If a luminescent material is mixed with a non-luminescent material, the surface of the luminescent material should be covered with a layer of organic or inorganic insulating material to prevent an energy escape or quenching in the luminescent material when excited.

### Luminescent organic materials:

Blue luminescent organic materials include the following materials:
Coumarin4; anthracene and its derivative diphenylanthracene (DPA); 9,10-di-2-naphthylanthracene (AND), perylene and its derivative thtra(t-butyl)-perylene (TBP); pyrene and its derivative, such as tetra (phenyl)-pyrene (TPP), distyrylarylene (DSA) and its derivative (DSA-Ph); fluorene and its derivative, such as DBSF, stilbene and its derivative; TPD (triphenyldiamine); N,N'-diphenyl-N,N'-bis(1-naphthyl)-(1,1'-biphenyl)-4,4'-diamine (NPB); 4,4'-N,N-dicarbazole-biphenyl (CBP); oxazole derivative (2-(4-biphenyl)-5-(4-tert-butyl)-1,3,4-ozadiaxole) (PBD), 3-phenyl-4-(8-naphthyl)-5-phenyl-1,2,4,-triaxole (TAZ); silole and its derivative 2,5-diarylsiloes; dithienosiles; aluminum metal complex BAlq; iridium metal complexes iridium (III) bis [(4,6-difluorophenyl)-pyridinato-N,C] picolinate (FIrpic) and etc.

### Green luminescent organic materials include the following materials:

Coumarin serial derivatives such as 3-(2-benzothiazolyl-tetrahydro)-7-diethylamino-2H-1-benzopyran-2-one (C6), C7, C545MT; quinoxaline derivative (6-N, N-dimethylamino-1-methyl-3-phenyl-1-H-Pyrazolo [3,4-b]-quinoline (PAQ-Net2), quinacridone serial derivatives such as dimethyl-quinaridone (DMQA); tetracene and its derivative DPT (diphenyltetracene), fluorene derivatives, aluminum metal complexes tris(8-hyroxy-quinoline)-aluminum (Alq), magnesium metal complexes Mgq; zinc metal complexes ZnPBO, ZnPBT; terbium metal complexes Tb(acac)₃Phen; iridium metal complexes tris(2-phenylpyridine) iridium, i.e., Ir(ppy)₃; (2-phenylphridine) iridium (III) acetylacetonate, i.e., (ppy)₃ Ir(acac) etc.

### Yellow luminescent organic materials include the following materials:

Tetracene derivative rubrene; triarylamine derivatives DCTP, phenoxazine (BTX), bis(8-hydroxyquinoline)-zinc(Znq), Rohdamine B, Rohdamine 6G etc.

### Red luminescent organic materials include the following materials:

Pyrane serial derivatives (4-(dicyano methylene)-2-methyl-6-(p-dimethylaminostyryl)-4H-pyran) (DCM2); DCJTB; triarylamine derivatives 1,1'-dicyano-substituted bis-styryl-naphthalene (BSN); NPAFN ; pentacene derivative diphenylpentacene (DPP); rohdamine B, rohdamine 6G; europium metal complexes Eu(DMB)₃Bath, Eu(acac)₃Phen; iridium metal complexes bis(2-(2'-benzo[4,5-a]thienyl)pyridinato-N, C) iridium (acetylacetonate), i.e., Btp₂Ir(acac) etc.

For a better energy conversion and preventing a concentration of quenching, luminescent materials may be doped with auxiliary dopants. For example, the blue luminescent material DSA-Ph may be doped with an auxiliary dopant TPD. The green luminescent material C6 may be doped with DMQD. The red luminescent material DCM2 may be doped with the green luminescent material C6 and yellow luminescent materials such as rubrene etc.

The above luminescent molecules may be incorporated through a chemical synthesis method into principal chains or side chains of non-conjugated macromolecules such as polypropylene, polyacrylate, polyvinyl alcohol, polyimide, polymethyl methacrylate, polystyrene, polycarbonate, polymerized silica resin, silicone resin or other known macromolecular materials.

Luminescent organic material may be solved, or dispersed into film-forming assistant materials, such as polypropylene, polyacrylate, polymethyl methacrylate, polyvinyl alcohol, polyimide, polystyrene, polycarbonate, phenolic resin, alkyd resin, epoxy resin, and polyamine resin, or other known macromolecular materials, to have a processable material. Other functionally assistant materials, such as a photosensitive material, a cross-linking material, a dispersion material, a solvent and etc. could be also added at the same time.

### Organic macromolecular materials:

Luminescent conjugated macromolecular materials include polyparaphenylene (PPP) and its derivatives, polyfluorene (PF) and its derivatives, polyparaphenylene vinylene (PPV) and its derivatives, such as P-PPV, OR-PPV, MEH-PPV, CN-PPV etc, polyacetylene derivatives PDPA and PHPA etc, polythiophene (PT) and its derivatives, polypyridine (PPY) and its derivatives, polyvinylenepyridine (PVY) and its derivatives; copolymers of said polymers, such as copolymer of polyfluorene and triarylamine (TFB), copolymer of polyfluorene and benzothiadiazole (F8BT), copolymer of polyfluorene and thiophene (F8T2); a dendrimer or oligomer formed film.

Luminescent conjugated macromolecules could be doped with assistant polymers (oligomers), including polypropylene, polyacrylate, polymethyl methacrylate, polyvinyl alcohol, polyimide, polystyrene, polycarbonate, phenol-formaldehyde resin, alkyd resin, epoxy resin, polyurethane resin or other known macromolecular materials, to prepare a processable material. Other functionally assistant materials, such as a photosensitive material, a luminescent assistant material, a cross-linking material, a dispersion material, a solvent and etc. could be also added at the same time. Photosensitive and thermosensitive polymeric functional groups may be added into principal chains or side chains of conjugated macromolecules in a chemical synthesis method to prepare a photosensitive and thermosensitive material.

Under the excitation of an ultraviolet or cyan light with a wavelength of 350-550nm, the luminescent materials satisfying the requirements of the present invention may emit the following lights: a blue light with a peak value at a wavelength ranging from 400 to 500nm, a green light with a peak value at a wavelength ranging from 500 to 550nm, a red light with a peak value at a wavelength ranging from 600 to 700nm, with a half width of 70nm or less, and the photoluminescence quantum efficiency of the luminescent materials in the range of the wavelength of the excited light is 10%-90% or greater, preferably 50%-90% or greater. The thickness of the photoluminescence film is in the range of 0.1µm-1mm, typically in the range of 2-10µm. The optical density at the wavelength of the effectively excited light is greater than 10, and preferably in the range of 100-10000. The luminescent material has good heat-resistant and atmospherically resistant properties and good solubility or dispersibility in macromolecules and etc. Film-forming assistant macromolecular materials are transparent in the range of the visible light spectrum with a light transmittance of 30% or greater, preferably 70% or greater.

A luminescent material is formed into a film on a substrate directly via a physical vapor deposition (PVD), chemical vapor deposition (CVD), Sol-Gel or coating method. The pixel patterns are formed in a masking, photolithography, laser peeling, printing, transfer printing, ink-jet printing process and etc.

Another film-forming method is to disperse or dissolve a luminescent material into a transparent macromolecular material. Appropriate macromolecular base material has a light transmittance of 30% or greater, preferably 70% or greater, in the wavelength range of 350-780nm. Granules of the appropriate luminescent inorganic material are sized in the range of 0.01-10µm, and preferably smaller than 0.1µm. A luminescent material concentration is in the range of 0.1-99wt%, preferably 1-20wt%. Appropriate macromolecular materials include polyethylene, polyvinyl chloride, polypropylene, polyacrylic acid, polyacrylonitrile, polymethyl acrylate, polymethyl methacrylate, polyepoxy acrylate, polyurethane acryloyl, polyester acrylate, polybutylene, polyvinyl alcohol, polyvinyl pyrrolidone, polystyrene, polyvinyl acetate, polycarbonate, polyurethane, polyimide, phenolic resin, epoxy resin, polymerized silica resin, silicone resin, polysulfone, polyphenylene ether, polyether-ketone, acetate fibre, nitrocellulose etc., and the mixtures, copolymers, and oligomers of the above polymers.

Film-forming macromolecular materials also need to be doped with functionally assistant materials, such as a polymer monomer, an oligomer, a polymerizing initiator material, a cross-linking material, a dispersion material, a coupling material, and a solvent etc. The polymerizing initiator material comprises 1-hydroxy- hexamethylene phenyl ketone (HCPK), and 2-hydroxyl-2-methyl-l-phenyl propane-1-ketone (HMPP) etc. The dispersion material comprises polyoxyethylene alkyl phenyl ether, and polyvinyl alcohol diester, etc. The coupling material comprises organosilane, etc. The solvent comprises aromatic hydrocarbon etc. such as methylbenzene, dimethylbenzene; alcohol such as ethanol, isopropanol; ketone such as acetone, cyclohexanone; ester such as ethyl acetate, butyl acetate, and water etc.

The prepared materials (a luminescent material, a macromolecular material, and an assistant material) have a light transmittance of more than 30% in the visible light spectrum. The thickness of the luminescence film is in the range of 0.1µm-1mm, typically in the range of 1-20µm. The optical density in the wavelength of the effectively excited light is greater than 10, and preferably in the range of 100-10000. The pixel patterns are formed in a photolithography, laser peeling, printing, transfer printing, ink-jet printing process and etc.

In a direct photolithography method, a luminescent material is dispersed into a transparent photosensitive resin such as photopolymerizing acrylic resin, and photo cross-linking polyvinyl alcohol etc. The photopolymerizing acrylic resin comprises a photopolymerizing initiator, an acrylic monomer and an oligomer and other polymers and a solvent for a modulated film-formability of the material. The transparent photosensitive resin doped with inorganic luminescent materials is then prepared into a RGB sub-pixel pattern through coating, exposure (UV), developing and stripping of photoresist, rinsing, baking and curing processes etc. The physical properties of the finished film depend on the luminescent material selected and the concentration of the material doped, the granular size thereof and the surface treatment thereto, and the dispersing method etc.

In an etching method, an inorganic luminescent material is dispersed or solved into a photostable resin such as polyimide acid, and patterns are formed by etching. For example, a polyimide acid doped with a luminescent inorganic material is coated on a substrate, and the polyimide acid is coated with a photoresist (positive or negative) after being pre-baked, then a RGB sub-pixel pattern is formed through exposure (UV), developing, etching (removing the non-pixel area), stripping of photoresist, rinsing, curing i.e. polyimidizing processes etc.

In a printing method, a luminescent material is dispersed into such a resin transparent to a visible light as polyvinyl chloride, melamine resin, phenolic resin, alkyd resin, epoxy resin, polyurethane resin, polyester resin, maleic resin, polymethyl methacrylate, polyacrylate, polycarbonate, polyvinyl alcohol, polyvinyl pyrrolidone, hydroxyethyl cellulose, methylol cellulose and other functionally assistant materials, so to prepare a printing ink. A luminescence film is then formed by heat and laser transfer printing, printing processes including a contact mode and a non-contact mode such as an ink-jet printing method and other printing methods.

A black matrix is formed surrounding the luminescent sub-pixels for a reduced light interference and an improved contrast ratio. The black matrix is made from a photosensitive or photostable polymer doped with a black pigment or dye (e.g. a carbon black), in a photolithography, dyeing, electrocolouring, and printing process and etc, or heat and laser transfer printing, printing processes including a contact mode and a non-contact mode such as an ink-jet printing method and other printing methods. The black matrix may be made from Cr metal or its oxide (CrOx) by means of sputtering and photolithography processes. The thickness of the black matrix is in the range of 0.1µm-1mm. The thickness of a typical organic black matrix is 2-4µm, and the thickness of a typical Cr metal black matrix is 0.2µm. A white balance can be realized by utilizing a black matrix and sub-pixels of a different aperture ratio to regulate the ratio of an emergent light volume. The white balance of the sub-pixels of different colors can be adjusted by choosing the RGB luminescent materials of different quantum efficiencies.

In general, there is a difference in thickness between the pixels and the black matrix 111 so that a flattened film 112 is formed over the pixels and the black matrix. The flattened film is made from a thermo-curable acrylic resin or a photo-curable epoxy resin or other known materials. The thickness of the flattened film is in the range of 0.1-20µm, preferably 0.5-2µm.

The common electrodes 113 (the data or gate electrodes for a passive driven liquid crystal display, and which are not needed in a IPS crystal display) is formed on the flattened film 112 from transparent materials such as ITO, IZO, In2O3, SnO2, ZnO etc, by means of a sputtering process. They may also made from a transparent conductive organic material such as polythiophene, polyaniline etc in a coating process. The thickness of the common electrode is in the range of 0.02-1µm, and the typical surface resist is 10-20 ohms. Spacers, structures (protrusions, slits) etc. are formed on the transparent common electrodes as required. The common electrode may be also formed in a photolithography, transfer printing, ink-jet printing process, etc.

The photoluminescence film 110' may have a light-absorptive function, and the spectrum of the emergent light is changed by a partially light absorption so as to improve the contrast ratio and the color purity and regulate the white balance. One way is to prepare a luminescent color film on the traditional absorptive color filter; another way is to dope the luminescent material with a translucent material to improve the contrast ratio and the color purity and adjust the photoluminescence efficiency. In the latter way, the luminescent material and the translucent material is insulated by an insulating material, for example, by means of a layer of transparent organic or inorganic insulating material (micro encapsulation) covered over the surfaces of the luminescent material and the translucent material, to prevent an electron transfer between the materials, i.e. to prevent the luminescent material from quenching.

The method of preparing the absorptive color filter is illustrated as follows.

The absorptive material comprises anthraquinone pigment (only red light permeable), halogenated (chlorine, bromine) phthalocyanine (only green light permeable), copper phthalocyanine and its derivatives (only blue light permeable) etc. Other pigments are listed as follows: red pigments including anthraquinone serial pigments, perylene serial pigments, DPP (diketone pyrrole) pigment, lake toner, diimide serial pigments, quinacridone serial pigments, anthracene serial pigments, isoindorine serial pigments, isoindorinone serial pigments, and the mixtures of these pigments; green pigments including halogenated phthalocyanine serial pigments, halogenated copper phthalocyanine serial pigments, triphenyl methane serial alkaline pigments, isoindorine serial pigments, isoindorinone serial pigments, and the mixtures of these pigments; blue pigments including copper phthalocyanine serial pigments, indanthrene serial pigments, indophenol serial pigments, cyanine serial pigments, dioxane phthalein serial pigments and a mixture of these pigments.

The pigments are dispersed into a photosensitive resin such as acrylic serial resins, methacrylic serial resins, poly vinyl cinnamate serial resins, cycloolefin rubber serial resins, which are a photo-curable photoresist material with a reactive ethenyl, and the dyed film is formed into a pattern through photolithography. Another way is to mix the pigments into a transparent resin such as polymethacrylate, polyvinyl chloride, vinyl chloride cerotic ethylene copolymer, alkyd resin, phenolic resin, aromatic sulphamide resin, urea-formaldehyde resin, melamine resin, epoxy resin, polyester resin, maleic resin, polyamide resin, polyurethane resin, polymethyl methacrylate, polyacrylate, polycarbonate, polyvinyl alcohol, polyvinyl pyrrolidone, hydroxyethyl cellulose, methylol cellulose, so as to prepare a printing ink, and a film is then formed by a photolithography, heating and laser transfer printing, printing process including a contact mode and a non-contact modes such as a ink-jet printing method and other printing methods.

The liquid crystal cell 210 is formed by sticking the array substrate and the above-mentioned color luminescent substrate together with a liquid crystal filled therebetween. The liquid crystal operates in a known mode such as TN, IPS, MVA, PVA, OCB, FLC, BN (bi-stable), PDLC etc. A gap of about 1-10µm between the array substrate and the color luminescent substrate is accurately determined by the spacers. Gate lines, data lines and electrodes are formed on the array substrate with a single layer of Al (alloy), Mo (alloy), Cr, Cu (alloy), Ta (alloy), Ti (alloy), W (alloy) or a combination thereof by sputtering and photolithography. The preparation of the color luminescent substrate has been described in the above, wherein a plurality of alternated three fundamental colors of red, green and blue (RGB) form a pattern, which is located corresponding to the respective pixels. The substrate is stuck with a polarizer.

The gate lines (which also act as pixel electrodes) and the data lines (which also act as pixel electrodes) of the passive matrix liquid crystal are respectively formed on the array substrate and the color luminescent substrate, without electronic switch elements such as thin film transistors, diodes or other non-linear elements, storage capacitors etc.

Electronic switch elements such as thin film transistors, diodes or other non-linear elements and storage capacitors connected in series with TFTs and connected in parallel with the liquid crystal cell are fabricated at the intersections of the gate lines and data lines on the arraysubstrate of the active matrix liquid crystal display. The electronic switches may be made from an inorganic semiconductor such as a-Si (amorphous silicon), p-Si (polysilicon), CdS, ZnO etc; or an organic semiconductor such as pentacene, CuPC (copper phthalocyanine), polythiophene etc. The pixel electrodes are made from a transparent or opaque conductive material for transmitting electronic signal in the data lines, wherein the transparent conductive material usually comprises an alloy of indium tin or zinc oxide i.e. ITO or IZO film, the reflective opaque electrodes are made of a highly reflective metal film such as Al, Ni, Mo, Ti, Ag etc, and the semi-reflective or translucent electrodes are made from ITO, Al etc. Transparent common electrodes are also formed on the substrate of the photoluminescence film.

The cell is formed after the array substrate and the color luminescent substrate are fabricated. PI (polyimide) film with thickness of 0.05-0.1µm is printed on the two substrates, and then the PI film on the substrates is rubbed. Then a sealing glue, an ultraviolet-curable epoxy resin, is dispersed on the frames of the panel. Spacers are placed between the two substrates to maintain a gap (2-10µm) there between. Then Ag (Au) glue is coated for connections of the common electrodes on the upper and lower glass substrates. The injection of the liquid crystal is realized by means of ODF or vacuum injection.

The polarization of the liquid crystal molecules is controlled by applying voltage to the pixel electrodes of the array substrate, so that a volume of light transmission can be changed. The ON/OFF states of TFT can be controlled by a scanning voltage from an external driving circuit. When TFT is in an ON state, static charges are written into the pixel electrodes (transparent electrodes) connected at the source side from the data lines connected at the drain side of TFT; the liquid crystal molecules are driven by a charged driving voltage through the data lines and the pixel electrodes. When TFT is in an OFF state, the liquid crystal cell and the storage capacitor connected parallel to the liquid crystal cell will hold the charges in the pixel at the previous level so that the pixel can keep the working state during one frame.

### Embodiment 1

The display device of the present embodiment may have any one of the structures illustrated in Figs. 4-6, the difference from the prior art lies in that a CCFL or GaInN blue light source 310' is used here and a photoluminescence film 110' is provided on the first substrate 116a

A CCFL tube, a light source 310', has a diameter of 1.8mm, and is as long as the size of LCD panel.

In addition, in the embodiment shown in Fig. 4, an ultraviolet stopping film 117 is provided on the photoluminescence film 110'.

The luminescent material of green luminescent sub-pixels 110b' is selected from coumarin (C6) or dimetheylquinacrodone (MDQD) serial derivatives, or a mixture of two or more luminescent materials. The film-forming material comprises acrylic photosensitive gel. The weight ratio of the coumarin (C6) and the acrylic resin (to the solid components of the photoresist) is 2-10%.

The luminescent material for red luminescent sub-pixels 110a' is selected from DCM2 (4-(dicyanomethylene)-2-methyl-6-(p-dimethylaminostyryl)-4H-pyran) or DPP (diphenylpentacence), and may be doped with green luminescent materials such as coumarin (C6) or dimetheylquinacrodone (MDQD) serial derivatives, or yellow luminescent materials etc for an improved blue-red light conversion efficiency. The film-forming material comprises an acrylic photosensitive gel. The weight ratio of the luminescent material such as DCM2 etc. and the acrylic resin (to the solid components of the photoresist) is 2-10%.

The above luminescent materials may be doped with a small amount of selectively absorptive pigments to adjust the contrast ratio, the color purity and the luminous intensity. The green photoresist is doped with (chlorine, bromine) phthalocyanine or copper phthalocyanine. The red light powder is doped with an anthraquinone pigment or a DPP pigment, which is covered with a layer of transparent insulating material (micro encapsulaltion) to prevent the electron transfer between the materials, i.e., to prevent a luminescence quenching in the luminescent materials.

A flattened film 112 is formed on the blue (blank in embodiment 1), green and red sub-pixels 110'. The flattened film is made from a heat-curable acrylic resin. The thickness of the flattened film is 0.5-10µm.

A transparent conductive film such as ITO (indium tin oxide) or IZO (indium zinc oxide) with a thickness of 0.04-0.2µm and a square resistance of 10-20ohm is formed on the above substrates in a sputtering process. The spacers (structures) are formed by photolithography.

The light valve unit 210 comprises a liquid crystal cell.

The operation of the embodiment will be described heretobelow. A blue light emitted from the light source 310' passes through the liquid crystal cell 210, which is applied with a voltage from an external circuit to control a volume of transmission of the blue light through the liquid crystal cell. The blue sub-pixels 110c' of the photoluminescence film is made from a colorless transparent polyacrylic resin. The blue light transmitted through the liquid crystal cell 210 is substantially emitted out except the light reflected back at the interface. The green sub-pixels 110b' of the photoluminescence film absorb the blue light and emit a green light (500-570nm), and the emitted light depends on the photoluminescence efficiency of the luminescent material. For example, if the material is C6, the efficiency is 80%, or most of the blue light is converted into a green light. The red sub-pixels 110a' of the photoluminescence film absorb the blue light and emit a red light (600-700nm), and if the photo-luminescent material is DCM2 and the efficiency is 80%, or most of the blue light is converted into a red light. A color display is realized through the above technology. Compared with a liquid crystal display with a white CCFL light source of the same power and such an absorptive color filter, the brightness of the display of the present invention is significantly improved, or if the brightness is the same, cost and energy is saved.

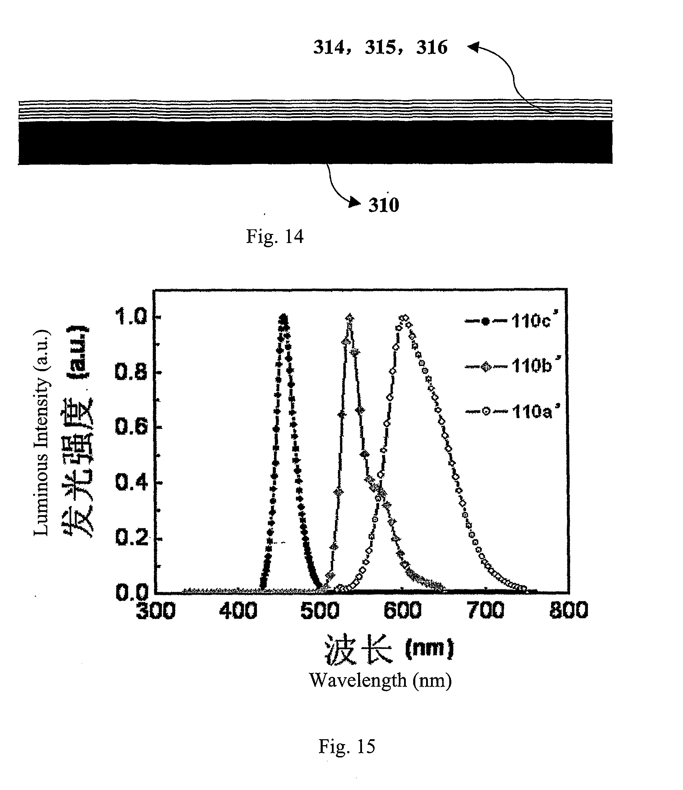

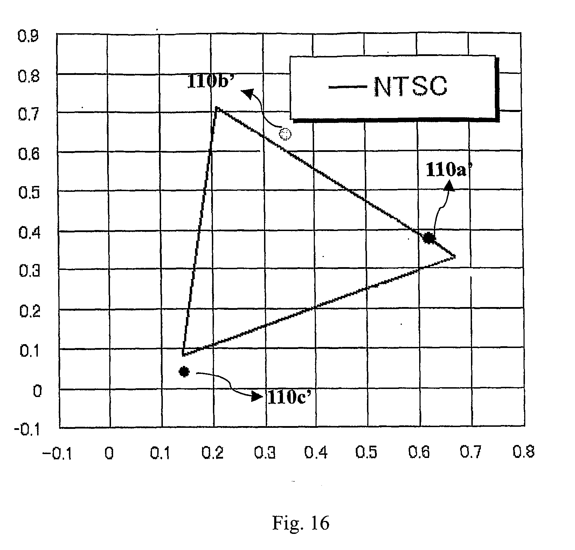

Fig. 15 illustrates a spectral diagram of the first embodiment, wherein C6 and DCM2 excited by a blue LED (460nm) respectively emit a green light (with a peak value at 530nm), and a red light (with a peak value at 610nm), which shows that the solution of the present embodiment is realizable. Fig.16 illustrates a color coordinate diagram in CIE1931 color gamut of the first embodiment, wherein C6 and DCM2 excited by a blue LED (460nm) respectively emit a 530nm light (green), and a 610nm light (red), which shows that the first embodiment satisfies the requirements of a generally industrial manufacture. As shown Fig. 16, NTSC is the abbreviation of the National Television System Committee.

### Embodiment 2

The present embodiment is configured and operates similarly to the first embodiment, but is different in that:
The luminescent inorganic materials for preparing the green luminescent pixels 110b' are selected from ZnS/Cu or SrCa2O4/Eu, or a mixture of two or more luminescent materials. The weight ratio of the materials to the solid components of the photoresist is 1-20%.
The luminescent inorganic materials for preparing the red luminescent pixels 110a' are selected from Y2O2S/Eu or SrS/Eu, or a mixture of two or more luminescent materials. Their weight ratio to the solid components of the photoresist is 1-20%.

### Embodiment 3

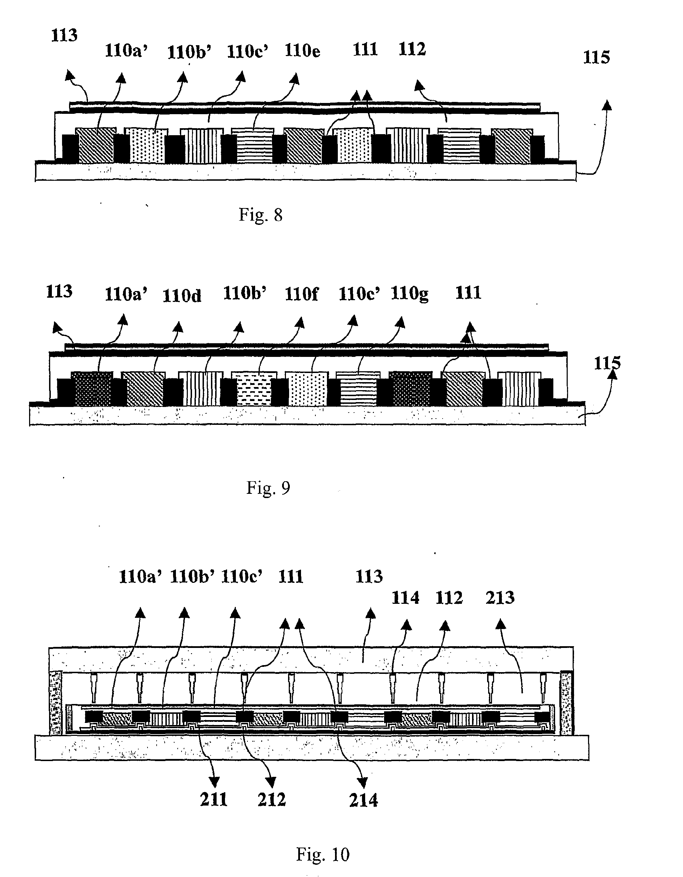

The configuration of the present embodiment is illustrated in Figs. 4 and 9 and is similar to the first embodiment, but different in that:
The light source 310' comprises a CCFL or GaInN ultraviolet LED light source.
The materials for the blue luminescent pixels 110a' are selected from luminescent organic materials of anthracene, TPD (triphenyldiamine), or luminescent inorganic materials of BaMg2Al6O27/Eu, (Ca, Sr)10(PO4)6Cl2/Eu, or a mixture of two of those luminescent materials.
The operation is in that: the blue sub-pixels 110c' of the photoluminescence film absorb the violet light and emit a blue light (400-500nm), and the light emitted depends on the photoluminescence efficiency of the luminescent material; the green sub-pixels of the photoluminescence film absorb the blue light and emit a green light (500-570nm), and the green light emitted depends on the photoluminescence efficiency of the luminescent material; the red sub-pixels of the photoluminescence film absorb the blue light and emit a red light (600-700nm), and the red light emitted depends on the photoluminescence efficiency of the luminescent material. RGB color display is realized by the above technology. Since an ultraviolet light is used for excitation, the range of selecting luminescent materials is expanded, and the color gamut of the display is also expanded, for example, so that six fundamental colors (dark blue, blue, green, Kelly, yellow, red) can be displayed.

### Embodiment 4

The configuration of the present embodiment is illustrated in Fig. 7 and is similar to the first or second embodiment, but different in that:
The yellow pixels is formed by organic material or rubrene or inorganic material of Y3Al5O12:Ce. The operation of the present embodiment is the same as the third embodiment. The luminescent sub-pixels include blue, green, yellow and red ones. A blue light emitted from a light source passes through the liquid crystal cell which is applied with a voltage from an external circuit to control a volume of the blue light transmitted through the liquid crystal cell. The blue sub-pixels of the photoluminescence film are made from a colorless transparent polyacrylic resin. The blue light transmitted through the liquid crystal cell is substantially emitted out except that reflected back at the interface. The green sub-pixels of the photoluminescence film absorb the blue light and emit a green light (500-570nm), and the light emitted depends on the photoluminescence efficiency of the luminescent material; the yellow sub-pixels of the photoluminescence film absorb the blue light and emit a yellow light (550-580nm), and the green light emitted depends on the photoluminescence efficiency of the luminescent material; the red sub-pixels of the photoluminescence film absorb the blue light and emit a red light (600-700nm), and the red light emitted depends on the photoluminescence efficiency of the luminescent material. A RYGB color display is realized by the above technology, and the color gamut of the display is greatly expanded.

### Embodiment 5

The configuration of the present embodiment is illustrated in Fig. 8 and is similar to the first or second embodiment, but different in that:
Rubrene, an organic material, or Y3Al5O12:Ce, an inorganic material is used as a yellow luminescent material to form white pixels. As a dopant concentration is very low in the yellow luminescent materials, an exciting blue light is not completely converted so that a white light is emitted. The operation of the present embodiment is the same as the previous embodiment, and the difference lies in that the white pixels are added and the luminescent sub-pixels include blue, green, red and white ones. A violet light emitted from a light source passes through the liquid crystal cell which is applied with a voltage from an external circuit to control a volume of the blue light transmitted through the liquid crystal cell. The blue sub-pixels of the photoluminescence film absorb the violet light and emit a blue light (400-500nm), and the light emitted depends on the photoluminescence efficiency of the luminescent material; the green sub-pixels of the photoluminescence film absorb the blue light and emit a green light (500-570nm), and the green light emitted depends on the photoluminescence efficiency of the luminescent material; the red sub-pixels of the photoluminescence film absorb the blue light and emit a red light (600-650nm), and the red light emitted depends on the photoluminescence efficiency of the luminescent material. The white sub-pixels of the photoluminescence film partially absorb the violet light and emit a composite white light (400-700nm) consisting of a blue light and a yellow light. A RGBW color display is realized by the above technology, and the brightness of the display is significantly improved.

### Embodiment 6

The present embodiment has the same configuration as the embodiments 1-5. The difference lies in that: the luminescent material comprises an organic-inorganic complexes, i.e. a mixture of a blue light inorganic material and a blue light organic material, a mixture of a green light inorganic material and a green light organic material, a mixture of a red, yellow or white light inorganic material and a red, yellow or white light organic material.

### Embodiment 7

The configuration of the present embodiment is illustrated in Fig. 10 and is similar to embodiments 1-6, but different in that: the photoluminescence film is formed on the arrays, wherein the common electrodes are still kept on the substrate 115b. The pixel electrodes 213 are formed over the flattened film 112 of the photoluminescence film 110'.

### Embodiment 8

The configuration of the present embodiment is illustrated in Figs. 11, 12 and is similar to embodiments 1-7 but is different in that: the areas of the photoluminescence films 110a', 110b', 110c' are not equal.

### Embodiment 9

The configuration of the present embodiment is illustrated in Fig. 13 and is similar to embodiments 1-7 but is different in that: the photoluminescence film has a partially absorptive function. In the present embodiment, the photoluminescence films 10a', 110b', 10c' are formed on the respective absorptive color filters 110a, b, c, which are the RGB sub-pixels of the absorptive color filters corresponding to the photoluminescence films. In the present embodiment, the light source is different or is a spectrum-broader or polychromatic light source, which for example has two sections of spectrums of 350-550nm, 400-550nm, 400-500nm plus 600-650nm, with unnecessary wave bands filtered out by the absorptive color filter.

### Embodiment 10

The present embodiment is configured similarly to embodiments 1-9 but different in that a blue or ultraviolet light source is directly projected to a luminescent color wheel via an optical system, and the light valve unit is a DMD or a black and white LCOS.

### Embodiment 11

The elements are similar to embodiments 1-10, but different in that the liquid crystal cell 210 utilizes an IPS mode.

### Embodiment 12

The elements are similar to embodiments 1-10, but different in that the liquid crystal cell 210 utilizes an MVA or PVA mode.

### Embodiment 13

The elements are similar to embodiments 1-10, but different in that the liquid crystal cell 210 utilizes an OCB mode.

### Embodiment 14

The elements are similar to embodiments 1-13, but different in that the active driven electronic switch elements for the liquid crystal cell 210 are made of polysilicon TFT, monocrystalline silicon FET (field effect transistor), organic semiconductor (pentacene) TFT etc.

### Embodiment 15

The elements are similar to embodiments 1-13, but different in that the array substrate is not provided with electronic switch elements 214 (TFT), 215 (storage capacitor). The passive driven liquid crystal cell is made in a TN, STN, BN (bi-stable), FLC (ferro-electric), AFLC (anti-ferro-electri), GH (guest-host), PDLC (polymer dispersed liquid crystal) mode, etc.

### Embodiment 16

The elements are similar to embodiments 1-15, but different in that the light source 310' is a planar light source such as FFL (Flat Fluorescent Lamp), EL, FED, OLED etc, and thus can work without a light guiding plate and a reflective plate. The schematic view of the embodiment is shown in Fig.14.

### Embodiment 17

The elements are similar to embodiments 1-16, but different in that the photoluminescence film 110' may be formed on a mechanically rotatable color wheel. A blue or ultraviolet light source 310' casts its light directly to the luminescent color wheel 110 via an optical system. The light valve unit 210 is a monolithic DMD or LCOS (black and white LOS), and the color is realized through a field sequence color. The schematic view of the embodiment is shown in Fig. 6a. The blue or ultraviolet light source 310' may be a gas discharge projective lamp.

### Embodiment 18

The elements are similar to embodiments 1-16, but different in that the light valve unit 210 is a reflective liquid crystal, and the pixel electrodes 213 of the array substrate thereof is made of opaque metals such as Mo, A1 and inorganic material (TiO2) etc. The photoluminescence film 110' is integrated onto the array substrate 115a. The blue or ultraviolet light source 310' casts its light directly to the reflective liquid crystal cell or LCOS (the liquid crystal cell, the luminescent color film and the driving circuit etc being formed on a Si substrate) via an optical system such as PBS (Polarized Beam Splitter) 316. The schematic view of the embodiment is shown in Fig. 6b. The blue or ultraviolet light source 310' may be a gas discharge projective lamp.

### Embodiment 19

The elements are similar to embodiments 1-15, but different in that the PDP (Plasma Display Panel) is utilized as a light valve unit as well as a light source. The embodiment utilizes a light of 350-550nm emitted by an inert gas discharging, which is different from a conventional PDP excited by a vacuum ultraviolet (174 nm).

The present invention has been illustrated in accordance with the exemplary embodiment, and it should be understood by the person in the art that the invention may be modified and changed within the spirit of the invention and the scope defined by the supplementary claims.

## Claims

1. A display device, comprising one or more substrate(s) and light valves disposed on the substrate(s), a light source provided on one side of the substrate, and a polarizer provided in front of the light source,
**characterized in that,**
more than one photoluminescence films are provided in front of the light source emitting a light with a wavelength in the range of ultraviolet or cyan, and under the excitation of the light source, the photoluminescence films emit a red light, a green light, a blue light and/or an intermediate color light among red, green and blue lights.

2. The display device according to claim 1, wherein the light emitted from the light source has peak value at a wavelength in the range of 350-560 nm.

3. The display device according to claim 1, wherein a portion of the photoluminescence film is transparent.

4. The display device according to claim 1, wherein the light source is operated in a static manner or controlled by the display image signal.

5. The display device according to claim 1, wherein an ultraviolet light stopping film is provided on the outer side of the substrate.

6. The display device according to claim 1, wherein the photoluminescence film is provided on a corresponding color filter.

7. The display device according to one of claims 1-6, wherein the light source is a cold cathode fluorescent lamp, a hot cathode fluorescent lamp, a gas discharge light source, an inorganic light emission diode, a planar fluorescent lamp, an organic light emission diode, an electroluminescent or field emission device light source.

8. The display device according to claim 7, wherein the light source is a side lighting type, a direct lighting type, a reflective type or a projective type.

9. The display device according to one of claims 1-6, wherein the photoluminescence film comprises a plurality of pixels surrounded with a black matrix.

10. The display device according to claim 9, wherein the black matrix is made from a metal, inorganic or organic composition.

11. The display device according to claim 9, wherein the black matrix has a uniform aperture ratio or a varied aperture ratio.

12. The display device according to claim 9, wherein the black matrix has a striped pattern, a triangular pattern, a Taiji-shaped pattern, or a mosaic pattern.

13. The display device according to claim 9, wherein a flattened film is provided over the pixels and the black matrix.

14. The display device according to one of claims 1-6, wherein the photoluminescence film is made from an inorganic composition, an organic composition or an inorganic-organic composition and functionally assistant materials, and the photoluminescence quantum efficiency of the photoluminescence film is greater than 10%.

15. The display device according to one of claims 1-6, wherein the photoluminescence film are formed by a physical vapor deposition, chemical vapor deposition, Sol-Gel method or coating process.

16. The display device according to one of claims 1-6, wherein the patterns of the photoluminescence film are formed by means of masking, photolithography, heat and laser transfer printing, laser peeling or printing process, wherein the printing process comprises a contact method or a non-contact method.

17. The display device according to one of claims 1-6, wherein the photoluminescence film has a partially light-absorptive function which is realized by doping an absorptive material, and the electron transfer between the materials is prevented by an insulating material between the luminescent material and the absorptive material.

18. The display device according to one of claims 1-6, wherein the photoluminescence film is formed on an absorptive color filter.

19. The display device according to one of claims 1-6, wherein the light valve unit is a liquid crystal cell, a digital micro device or plasma, and the plasma emits a monochromatic light or a polychromatic light with a peak value at a wavelength in the range of 350 to 550 nm.

20. The display device according to one of claims 1-6, wherein the light valve unit is passive or active.

21. The display device according to claim 20, wherein in the case of an active driven light valve unit, the electronic switch elements are thin film transistors, field effect transistors or diodes.

22. The display device according to claim 19, wherein the liquid crystal cell operates in a TN, STN, IPS, VA, OCB, FLC, AFLC, or PDLC mode.

23. The display device according to one of claims 1-6, wherein the substrate is made of a glass, plastic, metal or single-crystalline silicon.

24. A cellular phone comprising a display device according to one of claims 1-6.

25. A television set comprising a display device according to one of claims 1-6.

26. A computer comprising a display device according to one of claims 1-6.
